# EUROPÄISCHE PATENTSCHRIFT

(11) **EP 2 452 547 B1**
(45) Veröffentlichungstag und Bekanntmachung des Hinweises auf die Patenterteilung: **31.10.2018**
(21) Anmeldenummer: 10730744.9
(22) Anmeldetag: 22.06.2010
(51) Int. Cl.: H05K 3/34, H01L 33/48, H01L 33/62

(54) **ELEKTRONISCHES BAUTEIL**
ELECTRONIC COMPONENT
COMPOSANT ÉLECTRONIQUE

(30) Priorität: 08.07.2009 DE 102009032253
(43) Veröffentlichungstag der Anmeldung: 16.05.2012
(73) Patentinhaber: OSRAM Opto Semiconductors GmbH, 93055 Regensburg (DE)
(72) Erfinder: ZITZLSPERGER, Michael, 93047 Regensburg (DE); GRÖTSCH, Stefan, 93077 Lengfeld - Bad Abbach (DE)
(74) Vertreter: Epping - Hermann - Fischer
(86) Internationale Anmeldenummer: PCT/EP2010/058831
(87) Internationale Veröffentlichungsnummer: WO 2011/003732

(56) Entgegenhaltungen:
- GB-A- 2 392 778
- JP-A- 2001 036 154
- US-A1- 2002 113 245
- US-A1- 2004 051 171
- US-A1- 2006 043 566
- US-A1- 2008 237 627
- US-B1- 6 872 599

## Beschreibung

### Elektronisches Bauteil

Es wird ein elektronisches Bauteil sowie eine optoelektronische Vorrichtung mit einem elektronischen Bauteil angegeben.

Aus der Druckschrift US 2008/0237627 A1 ist ein LED-Bauteil mit einem Leiterrahmen bekannt, wobei sich der Leiterrahmen in einem Vergusskörper 3 befindet. US 2008/0237627 offenbart nicht, dass das LED-Bauteil eine Kontrollstelle, die ermöglicht, die stoffschlüssige Verbindung von elektrischen Anschlüssen mit einem Anschlussmaterial optisch zu kontrollieren, aufweist.

Die Druckschrift GB 2 392 778 A offenbart ein QFN-Bauteil mit einem IC-Chip, der sich an einem Chipträger eines Leiterrahmens mit Lötkontrollstellen befindet.

Der Druckschrift US 2004/0051171 A1 ist ein LED-Bauteil zu entnehmen, bei dem ein LED-Chip mittels eines Bonddrahts und eines Leiterrahmens elektrisch angeschlossen ist.

In der Druckschrift US 2002/0113245 A1 findet sich eine Radial-LED-Bauform, bei der elektrische Anschlussstifte durch eine Leiterplatte hindurchgeführt sind.

Ein LED-Bauteil, bei dem entweder innerhalb des Bauteils oder an Kanten desselben Lottaschen oder Lotkanten vorgesehen sind, ist der Druckschrift JP 2001-036154 A zu entnehmen. Eine zu lösende Aufgabe besteht darin, ein elektronisches Bauteil anzugeben, welches es ermöglicht, den Kontakt von elektrischen Anschlüssen des Bauteils optisch zu kontrollieren.

Erfindungsgemäß umfasst das elektronische Bauteil nach Anspruch 1 einen Grundkörper. Beispielsweise kann es sich bei dem Grundkörper um ein SMD-Gehäuse (surface mountable device) handeln. Der Grundkörper weist eine Oberseite sowie eine der Oberseite gegenüberliegende Unterseite auf.

An der Ober- und der Unterseite ist jeweils eine Fläche ausgebildet, die durch einen Teil der Außenfläche des Grundkörpers gebildet ist. Die Fläche an der Unterseite bezeichnet dabei jene Außenfläche des Grundkörpers, die einem Kontaktträger - beispielsweise einer Leiterplatte - im montierten Zustand zugewandt ist.

Erfindungsgemäß weist der Grundkörper an seiner Unterseite Anschlussstellen auf. Die Anschlussstellen des Bauteils sind dabei zur elektrischen Kontaktierung des Bauteils vorgesehen. Die Anschlussstellen sind an einer Unterseite des Bauteils von außen zugänglich, wobei die Unterseite des Bauteils gleichzeitig die Unterseite des Grundkörpers ist. Das heißt, an der Unterseite des Bauteils ist das Bauteil elektrisch kontaktierbar.

Erfindungsgemäß ist an der Oberseite des Grundkörpers am Grundkörper ein elektronisches Bauelement angeordnet. Das elektronische Bauelement ist leitend mit der Fläche an der Oberseite des Grundkörpers verbunden. Dazu kann das elektronische Bauelement auf die Fläche gebondet, gelötet oder elektrisch leitend geklebt sein. Bei dem elektronischen Bauelement kann es sich um einen strahlungsempfangenden oder um einen strahlungsemittierenden Halbleiterchip handeln. Beispielsweise handelt es sich bei dem Halbleiterchip um einen Lumineszenzdiodenchip, wie etwa einem Leuchtdiodenchip oder einem Laserdiodenchip.

Erfindungsgemäß weist der Grundkörper zumindest eine Seitenfläche auf, die zumindest eine Kontrollstelle mit einem ersten Bereich und einem zweiten Bereich aufweist. Die Seitenflächen sind diejenigen Flächen des Bauteils, die die Fläche an der Unterseite seitlich umschließen und beispielsweise in einer Richtung quer zu dieser Fläche verlaufen. Die Seitenflächen erstrecken sich von der Unterseite zur Oberseite und verbinden so die Flächen an Ober- und Unterseite. Die zumindest eine Kontrollstelle ist von außen zugänglich und, beispielsweise für einen externen Betrachter, frei einsehbar. "Frei einsehbar" bedeutet hierbei, dass die Kontrollstelle von außen optisch kontrolliert werden kann, ohne dass Teile der Kontrollstelle verdeckt oder abgedeckt sind, wenn das Bauteil auf einem Kontaktträger montiert ist. "Bereich" ist in diesem Zusammenhang eine Oberfläche, die die Seitenfläche zumindest stellenweise ausformt und bildet. Vorzugsweise ist die Kontrollstelle vollständig durch den ersten und den zweiten Bereich gebildet. Mit anderen Worten ist die Kontrollstelle Teil der Seitenfläche und ist selbst in zwei Bereiche unterteilt. Die Kontrollstelle ist ein Teil der Seitenfläche, der sich vom Rest der Seitenfläche beispielsweise hinsichtlich eines Materials unterscheidet.

Erfindungsgemäß ist der zweite Bereich als eine Einbuchtung im ersten Bereich ausgebildet. Mit anderen Worten ist die "Einbuchtung" eine Vertiefung, die beispielsweise eine Einkerbung oder eine Einwölbung im ersten Bereich ist. Der zweite Bereich ist von dem ersten Bereich zumindest stellenweise seitlich umrandet. Beispielsweise ist der zweite Bereich von dem ersten Bereich vollständig umschlossen.

Erfindungsgemäß enthalten der erste und der zweite Bereich unterschiedliche Materialien. "Unterschiedlich" bedeutet hierbei, dass die Materialien, mit denen der erste und der zweite Bereich jeweils gebildet sind, nicht identisch sind. Zum Beispiel kann sich der zweite Bereich durch eine zusätzliche Beschichtung vom ersten Bereich unterscheiden.

Das hier beschriebene elektronische Bauteil beruht dabei unter anderem auf der Erkenntnis, dass Anschlussstellen, welche an einer Unterseite eines elektronischen Bauteils angeordnet sind, von außen nicht einsehbar sind, wenn das elektronische Bauteil auf einem Kontaktträger - beispielsweise einer Leiterplatte - aufliegt. Die Anschlussstellen sind dann durch einen Grundkörper des elektronischen Bauteils verdeckt. Beispielsweise können so die Anschlussstellen nicht dahingehend kontrolliert werden, ob sie mit einem Anschlussmaterial ausreichend benetzt sind.
Ferner kann nicht sichergestellt werden, ob die Anschlussstellen des elektronischen Bauteils auch mit dem Kontaktträger elektrisch kontaktiert und/oder mechanisch verbunden sind.

Um nun die Anschlussstellen des Bauteils auf eine ausreichende Benetzung mit dem Anschlussmaterial kontrollierbar zu machen, macht das hier beschriebene Bauteil von der Idee Gebrauch, einen Grundkörper mit zumindest einer Seitenfläche zu verwenden, die zumindest eine Kontrollstelle aufweist. Die Kontrollstelle weist einen ersten Bereich und einen zweiten Bereich auf.

Werden nun sowohl die Anschlussstellen als auch die zumindest eine Kontrollstelle mit einem Anschlussmaterial in Kontakt gebracht und zeigt sich eine ausreichende Benetzung und physikalisch/chemisch stabile Verbindung zwischen dem Anschlussmaterial und der Kontrollstelle, so sind auch die Anschlussstellen mit dem Anschlussmaterial ausreichend benetzt und so nach dem Aushärten beispielsweise mit einem Kontaktträger elektrisch und mechanisch stabil verbunden. Ist also das elektronische Bauteil auf einem Kontaktträger aufgebracht, so ermöglichen die Kontrollstellen mittels visueller Kontrolle eine Aussage darüber, ob ebenso die Anschlussstellen mit dem Anschlussmaterials ausreichend benetzt sind.

Erfindungsgemäß ist der zweite Bereich mit einem Anschlussmaterial stärker benetzbar als der erste Bereich. Das heißt, dass das Anschlussmaterial mit dem zweiten Bereich eine stärkere physikalische und/oder chemische Verbindung als mit dem ersten Bereich eingeht und so das Anschlussmaterial beim Aufbringen auf den zweiten Bereich beispielsweise nicht "abperlt". Nach einem Aushärten ist das Anschlussmaterial stärker mit dem zweiten Bereich verbunden, sodass beispielsweise die Verbindungsstelle zwischen dem Anschlussmaterial und dem zweiten Bereich einer größeren äußeren mechanischen Belastung standhält als die Verbindungsstelle zwischen dem Anschlussmaterial und dem ersten Bereich. Das Anschlussmaterial kann beispielsweise ein Lot sein. Beispielsweise ist dann das Lot mit einem bleifreien oder bleihaltigen Lötzinn gebildet. Ebenso ist es möglich, dass das Anschlussmaterial mit einem Klebstoff gebildet ist. Beispielsweise handelt es sich bei dem Klebstoff um einen Silberleitklebstoff.

Erfindungsgemäß weist der Grundkörper einen metallischen Träger auf. Bei dem Träger kann es sich um einen metallischen Trägerstreifen (auch Leadframe) handeln. Beispielsweise ist der Trägerstreifen dann mit zwei streifenförmigen Metallstreifen gebildet. Der metallische Träger kann beispielsweise mit einem Kupfer gebildet sein.

Ebenso ist es möglich, dass der metallische Träger mit einem oder mehreren der Materialien Nickel, Palladium, Silber oder einer Mischung der genannten Materialien zusammen mit einem Kupfer gebildet ist.

Erfindungsgemäß ist der metallische Träger stellenweise von einem strahlungsundurchlässigen Gehäusekörper bedeckt. Es bilden der metallische Träger und der Gehäusekörper den Grundkörper. "Bedeckt" heißt in diesem Zusammenhang, dass der Gehäusekörper stellenweise mit dem metallischen Träger in direktem Kontakt steht und sich so an den Stellen zwischen dem metallischen Träger und dem Gehäusekörper weder ein Spalt noch eine Unterbrechung ausbildet. "Strahlungsundurchlässig" bedeutet hierbei, dass der Gehäusekörper für auf ihn auftreffende elektromagnetische Strahlung zu 80 %, bevorzugt zu 90 %, undurchlässig ist. Der Gehäusekörper kann mit einem duro- oder thermoplastischen Material, beispielsweise ein Epoxid, gebildet sein oder auch mit einem keramischen Material gebildet sein oder aus einem solchen bestehen. In das Material können zusätzliche strahlungsabsorbierende Materialien, beispielsweise Russpartikel oder andere Füllstoffe, eingebracht sein.

Erfindungsgemäß verbindet der Gehäusekörper den metallischen Träger und die Kontrollstelle mechanisch miteinander. Es wird so ein Bauteil geschaffen, welches ganz besonders stabil gegenüber beispielsweise äußeren mechanischen Einwirkungen ist. Ferner sind durch den Gehäusekörper der metallische Träger und die Kontrollstelle in ihrer Position zueinander stabilisiert. Ferner ist der Gehäusekörper elektrisch isolierend und zwischen dem metallischen Träger und der Kontrollstelle angeordnet.

Gemäß zumindest einer Ausführungsform sind der metallische Träger und/oder die Kontrollstelle in den Gehäusekörper zumindest teilweise eingebettet. Das kann heißen, dass der metallische Träger bis auf die Anschlussstellen und einen Montagebereich für das elektronische Bauelement von dem Gehäusekörper umschlossen ist. Das heißt, bevorzugt fasst der Gehäusekörper die Anschlussstellen des Bauteils zumindest stellenweise formschlüssig ein. Vorzugsweise schließen die Anschlussstellen dann vertikal bündig mit dem Gehäusekörper ab. "Vertikal" bezeichnet dabei diejenigen Richtungen, die in einer Ebene verlaufen, die sich senkrecht oder im Wesentlichen senkrecht zur Fläche an der Unterseite des Grundkörpers erstreckt. Das heißt, die Anschlussstellen befinden sich an der Unterseite des Grundkörpers und ragen nicht über den Gehäusekörper hinaus. Bevorzugt weisen dabei die Anschlussstellen eine Fläche auf, über die sie von außerhalb des Bauteils elektrisch kontaktierbar sind. Zumindest an der Anschlussfläche ist die Anschlussstelle dann nicht vom Gehäusekörper eingefasst.

Gemäß zumindest einer Ausführungsform sind die Anschlussstellen und die Kontrollstelle mit demselben Material gebildet. Beispielsweise sind die Anschlussstellen und die Kontrollstelle mit einem Kupfer gebildet, wobei die Anschlussstellen und die Kontrollstelle im zweiten Bereich dann zusätzlich mit einer metallischen Beschichtung, beispielsweise einer Gold- oder Silberbeschichtung, versehen sind. Ist die Kontrollstelle im zweiten Bereich ausreichend mit dem Anschlussmaterial benetzt, so ermöglicht dies eine Aussage darüber, dass, nach einer zusätzlichen In-Kontaktbringung der Anschlussstellen mit dem Anschlussmaterial, auch die Anschlussstellen ausreichend benetzt sind.

Gemäß zumindest einer Ausführungsform ist der Grundkörper mit einem keramischen Material gebildet. Ist der Grundkörper vollständig mit einem keramischen Material gebildet, so ist die Fläche an der Unterseite zumindest stellenweise mit einem elektrisch kontaktfähigen Material, beispielsweise einem Metall, beschichtet, wobei die beschichteten Stellen dann die Anschlussstellen ausbilden. Ferner kann dann der Grundkörper Chip-Anschlussstellen sowie Leiterbahnen zur Kontaktierung des elektronischen Bauelements aufweisen.

Gemäß zumindest einer Ausführungsform ist die zumindest eine Seitenfläche des Grundkörpers stellenweise mittels Vereinzelung erzeugt. Insbesondere sind Konturenformen der Seitenfläche also nicht durch einen Guss oder Pressprozess erzeugt, sondern mittels eines Vereinzelungsprozesses des Formkörpers. Das Vereinzeln kann beispielsweise mittels Sägen, Schneiden, Fräsen oder Herstellen einer Bruchkante und anschließendes Brechen erfolgen. Die Seitenfläche des Gehäusekörpers ist damit mittels eines Materialabtrags erzeugt. Die Seitenfläche weist dann bevorzugt Spuren eines Materialabtrags auf. Ist der Grundkörper mit dem metallischen Träger gebildet und wird bei der Herstellung des elektronischen Bauteils sowohl durch den Gehäusekörper als auch durch den metallischen Träger vereinzelt, geschnitten oder gebrochen, so schließen die Seitenflächen des metallischen Trägers lateral bündig mit dem Gehäusekörper ab. "Lateral" bezeichnet dabei diejenigen Richtungen, die in einer Ebene verlaufen, die sich parallel oder im Wesentlichen parallel zur Fläche an der Unterseite erstreckt. Die Seitenfläche ist dann sowohl stellenweise durch den Gehäusekörper als auch stellenweise durch den metallischen Träger gebildet. Die Stellen des Trägers durch die vereinzelt ist, können dann die Kontrollstelle ausbilden. Vorzugsweise wird bei der Vereinzelung jedoch nicht durch den zweiten Bereich der Kontrollstelle vereinzelt, sodass der zweite Bereich keine Spuren der Vereinzelung, beispielsweise keine Spuren eines Materialabtrags, aufweist.

Gemäß zumindest einer Ausführungsform ist der erste Bereich der Kontrollstelle mit einem Metall gebildet. Denkbar ist in diesem Zusammenhang, dass der Grundkörper einen metallischen Träger aufweist.

Gemäß zumindest einer Ausführungsform ist der erste Bereich der Kontrollstelle mit einem keramischen Material gebildet. Vorzugsweise ist dann auch der Grundkörper vollständig mit einem keramischen Material gebildet ist.

Gemäß zumindest einer Ausführungsform weist der zweite Bereich der Kontrollstelle eine metallische Beschichtung auf. Vorzugsweise sind sowohl die Anschlussstellen als auch der zweite Bereich der Kontrollstelle mit einer metallischen Beschichtung versehen. Bevorzugt ist die metallische Beschichtung der Anschlussstellen und des zweiten Bereichs der Kontrollstelle mit demselben Material gebildet. Die metallische Beschichtung ermöglicht vorteilhaft eine Einstellung, beispielsweise eine Erhöhung, der Benetzbarkeit mit dem Anschlussmaterial. Bei der metallischen Beschichtung handelt es sich beispielsweise um eine Schicht, die vorzugsweise mit Silber oder Gold gebildet ist.

Ferner wird eine optoelektronische Vorrichtung nach Anspruch 8 angegeben.

Erfindungsgemäß weist die optoelektronische Vorrichtung das elektronische Bauteil gemäß einer der vorhergehenden Ausführungsformen auf.

Erfindungsgemäß weist die optoelektronische Vorrichtung einen Kontaktträger auf, der zur elektrischen Kontaktierung des elektronischen Bauteils dient, wobei an einer Oberfläche des Kontaktträgers zumindest ein Montagebereich ausgebildet ist. Bei dem Kontaktträger kann es sich beispielsweise um eine Leiterplatte handeln, wobei der Montagebereich dann derjenige Bereich ist, auf dem das elektronische Bauteil montiert ist. Der Montagebereich ist also derjenige Bereich der Oberfläche des Kontaktträgers, der dem elektronischen Bauteil zugewandt ist und auf dem das elektronische Bauteil aufliegt. Dazu kann der Montagebereich zumindest stellenweise mit dem elektronischen Bauteil in mechanischem Kontakt stehen. Vorzugsweise befindet sich der Montagebereich mit dem Anschlussmaterial, über das das elektronische Bauteil elektrisch kontaktiert ist, in Kontakt. Das heißt, das Anschlussmaterial benetzt dann zumindest stellenweise zumindest die Anschlussstellen des Bauteils und damit auch Teile des Montagebereichs.

Erfindungsgemäß ist der zweite Bereich der Kontrollstelle mittels des Anschlussmaterials stoffschlüssig mit dem Montagebereich verbunden. "Stoffschlüssig" bedeutet hierbei, dass nach dem Aushärten des Anschlussmaterials das Anschlussmaterial mit dem zweiten Bereich eine feste Verbindung eingeht, welche beispielsweise auch gegen äußere mechanische Belastung stabil und belastbar ist. Vorzugsweise geht dann das Anschlussmaterial mit dem Material des zweiten Bereichs eine physikalische und/oder chemische Verbindung ein, sodass sich zwischen dem Anschlussmaterial und dem zweiten Bereich weder ein Spalt noch eine Unterbrechung ausbildet. Insbesondere ist das Anschlussmaterial mit dem zweiten Bereich bruchfest verbunden.

Erfindungsgemäß sind die Verbindungsstellen von der Oberfläche des Kontaktträgers aus frei einsehbar. "Frei einsehbar" bedeutet hierbei, dass die Kontrollstelle von der sich dem elektronischen Bauteil zugewandten Seite des Kontaktträgers aus visuell kontrolliert werden kann. So kann dann ein externer Betrachter die Kontrollstelle dahingehend kontrollieren, ob das Anschlussmaterial stoffschlüssig mit dem zweiten Bereich verbunden ist. Hat sich der zweite Bereich der Kontrollstelle stoffschlüssig mit dem Anschlussmaterial verbunden, so heißt das, dass auch die Anschlussstellen des elektronischen Bauteils stoffschlüssig mit dem Anschlussmaterial verbunden sind.

Gemäß zumindest einer Ausführungsform handelt es sich bei dem Anschlussmaterial um ein Lot. Handelt es sich bei dem Anschlussmaterial um ein Lötzinn so ist denkbar, dass der zweite Bereich der Kontrollstelle mit einer Silber- oder einer Goldbeschichtung versehen ist. Vorzugsweise ist im Falle einer Goldbeschichtung beispielsweise auf den mit Kupfer gebildeten metallischen Träger mittels einer Abscheidetechnik, beispielsweise stromlos, ein Verbund von mehreren Schichten, beispielsweise im zweiten Bereich der Kontrollstelle, auf den metallischen Träger abgeschieden. Vorzugsweise folgt der Verbund ausgehend vom metallischen Träger in Richtung des Anschlussmaterials der Schichtenfolge Nickel/Palladium/Gold. Ebenso ist denkbar, dass die Schichtenfolge des Verbunds mit anderen Materialien gebildet ist und/oder von der dargestellten Schichtenfolge abweicht.

Im Folgenden wird das hier beschriebene elektronische Bauteil sowie die hier beschriebene optoelektronische Vorrichtung anhand von Ausführungsbeispielen bzw. nicht erfindungsgemäßen Abwandlungen und den dazugehörigen Figuren näher erläutert.

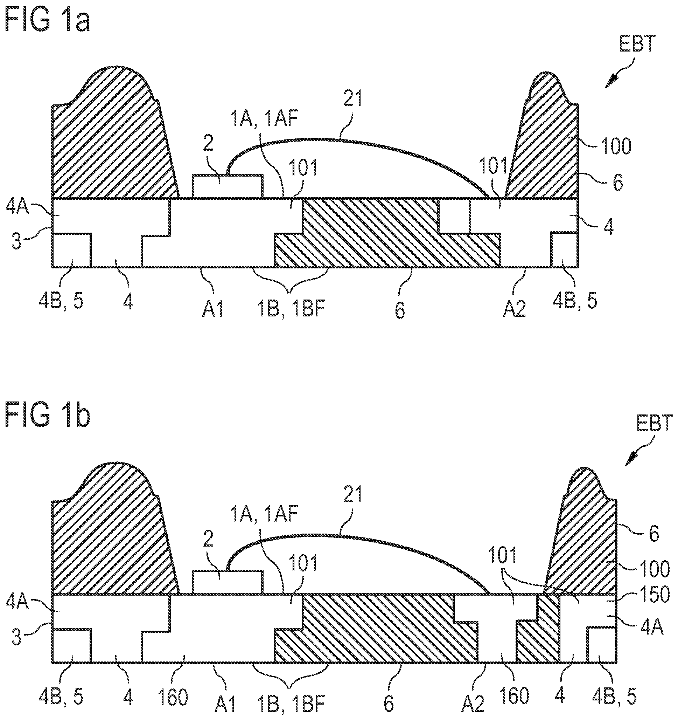

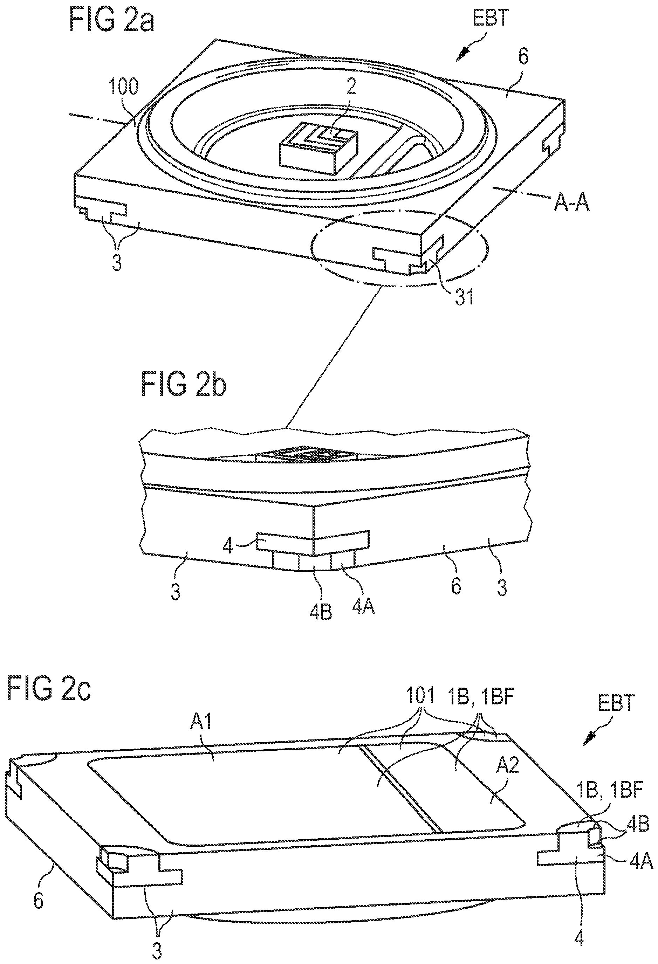

Die Figuren 1b, 2a, 2b und 2c zeigen schematische Ansichten von Ausführungsbeispielen eines hier beschriebenen elektronischen Bauteils.
Die Figuren 1a und 4 zeigen schematische Ansichten von Abwandlungen nicht erfindungsgemäßer elektronischer Bauteile.
Die Figur 3 zeigt in einer schematischen Draufsicht einen Trägerverbund zur Herstellung eines hier beschriebenen elektronischen Bauteils.
Die Figur 5 zeigt in einer schematischen Draufsicht einen Trägerverbund zur Herstellung einer nicht erfindungsgemäßen Abwandlung eines elektronischen Bauteils.
Die Figur 6 zeigt in einer schematischen Seitenansicht ein Ausführungsbeispiel einer hier beschriebenen optoelektronischen Vorrichtung.

In den Ausführungsbeispielen, Abwandlungen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis verschieden groß dargestellt sein.

Die Figur 1a zeigt in einer schematischen Schnittdarstellung entlang einer Schnittlinie A-A eine nicht erfindungsgemäße Abwandlung eines elektronischen Bauteils EBT. Ein Grundkörper 100 weist eine Oberseite 1A sowie eine der Oberseite gegenüberliegenden Unterseite 1B auf.

Ferner weist der Grundkörper 100 einen metallischen Träger 101 auf. Der metallische Träger 101 kann dabei beispielsweise mit einem Kupfer gebildet sein. Ferner ist der metallische Träger 101 stellenweise von einem strahlungsundurchlässigen Gehäusekörper 6 bedeckt. Der Träger 101 bildet dann zusammen mit dem Gehäusekörper 6 den Grundkörper 100. Gemäß dem Ausführungsbeispiel der Figur 1a bedeckt der Gehäusekörper 6 eine Fläche 1AF an der Oberseite 1A des Grundkörpers 100 bis auf einen Chipmontagebereich vollständig. An der Unterseite 1B des Grundkörpers 100 schließt der Gehäusekörper 6 lateral bündig mit Anschlussstellen A1, A2 des metallischen Trägers 101 ab. Das heißt, dass eine Fläche 1BF an der Unterseite 1B des Grundkörpers 100 eben ist und somit weder Erhebungen noch Senkungen oder Unterbrechungen aufweist und allein durch die Form des Grundkörpers 100 bestimmt ist.

Die Anschlussstellen A1 und A2 dienen zur elektrischen Kontaktierung des elektronischen Bauteils EBT. Die Anschlussstellen A1, A2 sind von der Unterseite 1B des Grundkörpers 100 frei zugänglich und vorliegend mit einem elektrisch kontaktfähigen Material, beispielsweise einer Silber- oder Goldbeschichtung, beschichtet.

Auf der Fläche 1AF, die stellenweise durch den Träger 101 gebildet ist, ist ein elektronisches Bauelement 2 angeordnet. Das elektronische Bauelement 2 ist mittels einer Bonddrahtkontaktierung 21 elektrisch mit dem metallischen Träger 101 kontaktiert. Bei dem elektronischen Bauelement 2 kann es sich um einen strahlungsempfangenden oder um einen strahlungsemittierenden Halbleiterchip handeln. Beispielsweise handelt es sich bei dem Halbleiterchip um einen Lumineszenzdiodenchip, wie etwa einem Leuchtdiodenchip oder einem Laserdiodenchip.

Ferner weist der Grundkörper 100 Seitenflächen 3 auf, welche mittels Vereinzeln erzeugt sind. Das Vereinzeln kann beispielsweise mittels Sägen, Schneiden, Fräsen, Herstellen einer Bruchkante und anschließendem Brechen oder einer anderen Form des Materialabtrags erfolgen. Die Seitenflächen 3 des Grundkörpers sind dann mittels eines Materialabtrags erzeugt. Die Seitenflächen 3 weisen dann bevorzugt Spuren eines Materialabtrags auf. Beim Vereinzeln wird dann sowohl durch den Gehäusekörper 6 als auch durch den metallischen Träger 101 vereinzelt, sodass die Seitenflächen 3 stellenweise durch den Gehäusekörper 6 und den metallischen Träger 101 gebildet sind.

Jede Seitenfläche 3 weist eine Kontrollstelle 4 mit einem ersten Bereich 4A und einem zweiten Bereich 4B auf, wobei der zweite Bereich als eine Einbuchtung 5 im ersten Bereich 4A ausgebildet ist.

Um den zweiten Bereich 4B mit einem Anschlussmaterial benetzbar zu machen, ist der Bereich 4B mit einer metallischen Beschichtung versehen. Beispielsweise handelt es sich bei der metallischen Beschichtung um eine Beschichtung, die mit Silber oder Gold gebildet ist. Bei der metallischen Beschichtung des Bereichs 4B handelt es sich um dasselbe Material, mit dem auch die Anschlussstellen A1, A2 beschichtet sind. Insbesondere wird beim Vereinzeln nicht durch den Bereich 4B vereinzelt, sodass der Bereich 4B der Kontrollstelle 4 keine Vereinzelungsspuren aufweist.

In der Figur 1b ist in einer schematischen Schnittdarstellung ein Ausführungsbeispiel eines elektronischen Bauteils EBT beschrieben, bei dem der metallische Träger 101 mit zwei voneinander getrennten Trägerteilen 150 und 160 gebildet ist. Der Trägerteil 150 weist dabei die Kontrollstelle 4 auf. Zwischen den Trägerteilen 150 und 160 ist der Gehäusekörper 6 angeordnet. Der Gehäusekörper 6 ist elektrisch isolierend und verbindet die beiden Trägerteile 150 und 160 mechanisch miteinander. Es ist gemäß dieser Ausführungsform ermöglicht, dass das die Kontrollstelle 4 aufweisende Trägerteil 150 zur Kontaktierung weiterer, beispielsweise externer, elektronischer Bauteile genutzt wird. Insbesondere ermöglicht das vorliegende Ausführungsbeispiel, dass das Trägerteil 160 und das Trägerteil 150 auf unterschiedlichen elektrischen Potentialen liegen und sich so zwischen den beiden Trägerteilen 150 und 160 eine elektrische Spannung ausbilden kann.

Die Figuren 2a, 2b und 2c zeigen in schematischen Drauf- und Seitenansichten sowie in Draufsichten von der Unterseite her das Ausführungsbeispiel gemäß der Figur 1b. Erkennbar ist wiederum jeweils die Kontrollstelle 4, welche durch den ersten Bereich 4A und den zweiten Bereich 4B gebildet ist. Der zweite Bereich 4B ist als Einbuchtung 5 im ersten Bereich gebildet, wobei die Einbuchtung 5 über eine durch jeweils zwei Seitenflächen 3 gebildete Eckkante 31 in Form einer "zylindersegmentartigen" Vertiefung erzeugt ist. "Zylindersegmentartig" bedeutet hierbei, dass die Einbuchtung 5 durch eine kontinuierlich gekrümmte Innenfläche sowie eine zur Innenfläche senkrecht verlaufende Eckinnenfläche gebildet ist.

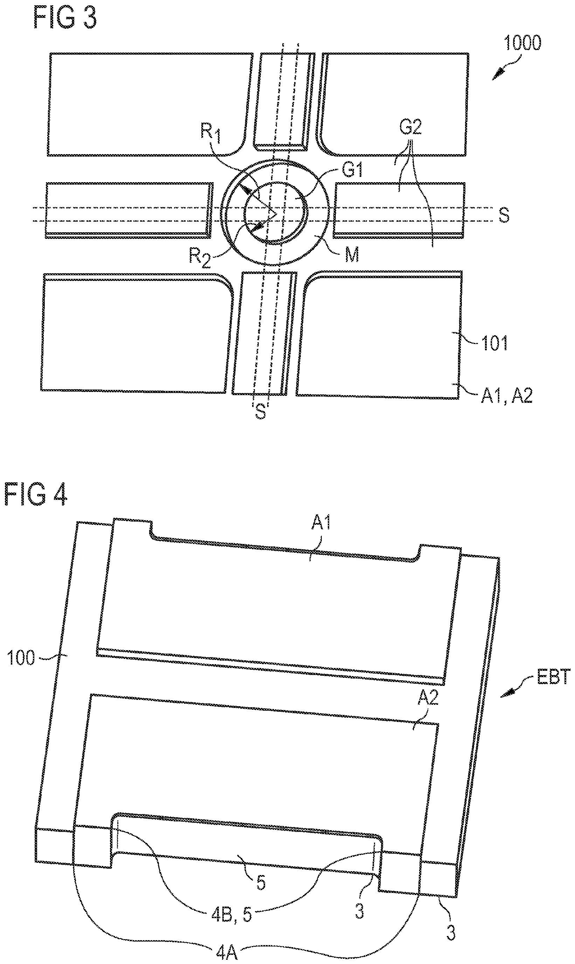

Die Figur 3 zeigt in einer schematischen Draufsicht einen metallischen Trägerverbund 1000. Zur Herstellung des Grundkörpers 100 wird Gehäusekörpermaterial auf Gebiete G2 des Trägerverbunds 1000 aufgebracht. Vorzugsweise wird derart viel Gehäusekörpermaterial auf die Gebiete G2 aufgebracht, dass nach dem Aushärten das Gehäusekörpermaterial sowohl mit den Anschlussstellen A1, A2 des späteren Grundkörpers 100 als auch mit einem durch den Trägerverbund 1000 gebildeten ringförmigen Zylinderring M vertikal bündig abschließt. In dem Trägerverbund 1000 bilden die Anschlussstellen A1, A2 sowie der Zylinderring M Erhebungen im Vergleich zur Oberfläche des Gebiets G2. Der Zylinderring M weist einen äußeren Radius R1 von 180 bis 220 µm, bevorzugt von 200 µm auf, wobei ein innerer Radius R2 Abmessungen zwischen 80 bis 120 µm, bevorzugt von 100 µm aufweist.

Vorzugsweise bleibt nach dem Vergießen das von dem Zylinderring M kreisförmig umschlossene Gebiet G1 frei vom Gehäusekörpermaterial. In einem nächsten Schritt kann nach dem Aushärten des Gehäusekörpermaterials zum Gehäusekörper 6 der Trägerverbund 1000 entlang einer Schnittlinie S in einzelne Grundkörper 100 vereinzelt werden. Nach dem Vereinzeln entlang der Schnittlinie S entsteht an den Stellen des Gebiets G2 jeweils der zweite Bereich 4B der Kontrollstelle 4 eines einzelnen metallischen Trägers 101. Mit anderen Worten wird der Zylinderring M durch den Vereinzelungsprozess segmentiert, sodass nach dem Vereinzeln jeder metallische Träger 101 jeweils die Einbuchtungen 5 in Form "zylindersegmentartigen" Vertiefungen aufweist.

Die Figur 4 zeigt in einer Draufsicht von der Unterseite her eine weitere nicht erfindungsgemäße Abwandlung eines elektronischen Bauteils EBT. Vorliegend ist der Grundkörper 100 mit einem keramischen Material gebildet, wobei der Grundkörper 100 auch in diesem Fall Anschlussstellen A1 und A2 aufweist. Die Anschlussstellen A1, A2 können mit einem metallischen Material gebildet sein, zum Beispiel mit einer metallischen Beschichtung, die beispielsweise mit Silber oder Gold gebildet ist. Der Grundkörper ist dann mit Leiterbahnen und Durchkontaktierungen von der Unterseite 1B zur Oberseite 1A versehen, sodass das elektronische Bauelement 2 mit den Anschlussstellen A1, A2 elektrisch kontaktiert ist.

Wie im vorangegangenen Figuren weist das Bauteil gemäß Figur 4 ebenso Seitenflächen 3 auf. Ferner weist wiederum jede Seitenfläche 3 die Kontrollstelle 4 mit dem ersten Bereich 4A und dem zweiten Bereich 4B auf, wobei der zweite Bereich als eine Einbuchtung 5 im ersten Bereich 4A ausgebildet ist.

Vorliegend ist der als Einbuchtung 5 ausgebildete Bereich 4B mit einem metallischen Material beschichtet. Dabei handelt es sich um dasselbe Material, mit dem auch die Anschlussstellen A1, A2 gebildet sind.

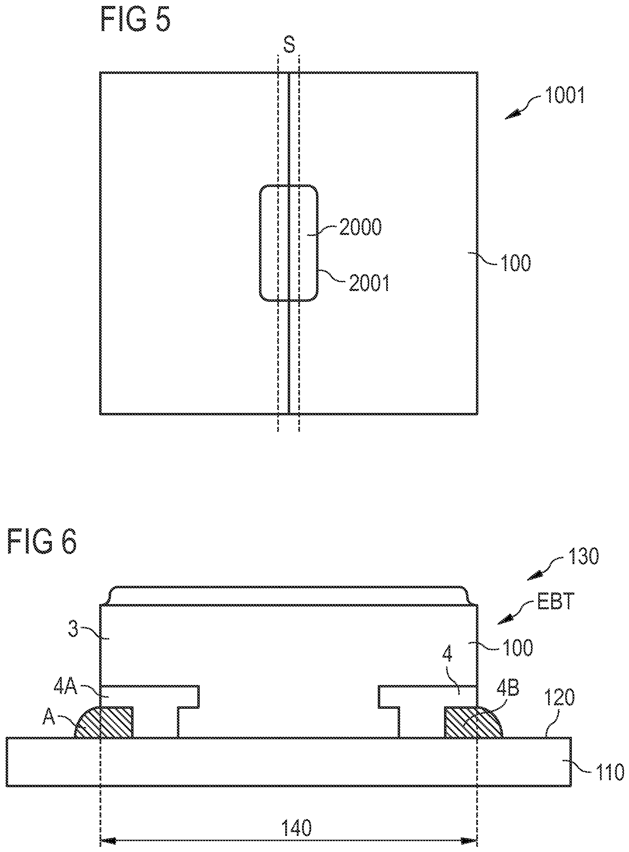

Die Figur 5 zeigt in einer schematischen Draufsicht einen keramischen Trägerverbund 1001. Der Trägerverbund 1001 weist Aussparungen 2000, die frei von Material und beispielsweise mit Luft gefüllt sind. Ferner weisen Innenwände 2001 der Aussparungen 2000 eine metallische Beschichtung auf. Die metallische Beschichtung kann beispielsweise mit Gold oder Silber gebildet sein. Entlang der Schnittlinie S wird der keramische Trägerverbund 1001 in einzelne Grundkörper 100 vereinzelt. Nach dem Vereinzeln sind die Innenwände 2001 von außen zugänglich und einsehbar. Das heißt, dass nach dem Vereinzeln durch die unterteilten Aussparungen 2001 jeweils der zweite Bereich 4B einer Kontrollstelle 4 in Form von Einbuchtungen 5 ausgebildet ist.

Die Figur 6 zeigt in einer schematischen Seitenansicht eine optoelektronische Vorrichtung 130 gemäß einem hier beschriebenen Ausführungsbeispiel. Auf einem Kontaktträger 110 ist an einer Oberfläche 120 des Kontaktträgers 110 auf einem Montagebereich 140 das elektronische Bauteil EBT angebracht. Bei dem Kontaktträger 110 kann es sich beispielsweise um eine Leiterplatte handeln, auf die das elektronische Bauteil EBT montiert ist. Der Montagebereich 140 ist dabei der Bereich der Oberfläche 120 des Kontaktträgers 130, der mit dem elektronischen Bauteil EBT zumindest stellenweise in mechanischem Kontakt steht. Das elektronische Bauteil EBT ist mit dem Kontaktträger 110 durch ein Anschlussmaterial A beispielsweise einem Lot oder einem Klebstoff, über die Anschlussstellen A1 und A2 sowohl elektrisch kontaktiert als auch mechanisch verbunden. Vorzugsweise ist auch der zweite Bereich 4B der Kontrollstelle 4 mittels des Anschlussmaterials A stoffschlüssig mit dem Montagebereich 140 verbunden. Das heißt, dass sich sowohl an einer Grenzfläche Anschlussmaterial A/zweiter Bereich 4B als auch an einer Grenzfläche Anschlussmaterial A/Montagebereich 140 weder ein Spalt noch eine Unterbrechung oder beispielsweise ein Lufteinschluss ausbildet. Die Kontrollstelle 4 ist von der Oberfläche 120 des Kontaktträgers 110 aus frei einsehbar.

Da die Anschlussstellen A1 und A2 des auf den Kontaktträger 110 aufgebrachten Bauteils EBT durch den Grundkörper 100 verdeckt sind, ermöglichen die hier vorgeschlagenen Ausführungsformen des hier beanspruchten Bauteils EBT mittels der seitlich frei einsehbaren Kontrollstellen 4 festzustellen, ob die Anschlussstellen A1 und A2 stoffschlüssig mit dem Anschlussmaterial A verbunden sind und das elektronische Bauelement dem Kontaktträger 110 so ausreichend elektrisch kontaktiert ist. Sind die Kontrollstellen 4 mit dem Anschlussmaterial A stoffschlüssig in Verbindung, so gilt dies ebenso für die Anschlussstellen A1 und A2.

## Patentansprüche

1. Elektronisches Bauteil (EBT), mit
- einem Grundkörper (100), der eine Oberseite (1A) sowie eine der Oberseite gegenüberliegende Unterseite (1B) aufweist, wobei der Grundkörper (100) einen metallischen Träger (101) aufweist und wobei der metallische Träger (101) an seiner Unterseite (1B) Anschlussstellen (A1, A2) zur elektrischen Kontaktierung des Bauteils (EBT) aufweist,
- einem elektronischen Bauelement (2), das an der Oberseite (1A) des Grundkörpers (100) am Grundkörper (100) angeordnet ist, wobei
- der Grundkörper (100) zumindest eine Seitenfläche (3) aufweist, die zumindest eine Kontrollstelle (4) mit einem ersten Bereich (4A) und einem zweiten Bereich (4B) aufweist,
- der zweite Bereich (4B) als eine Einbuchtung (5) im ersten Bereich (4A) ausgebildet ist,
- der erste (4A) und der zweite Bereich (4B) unterschiedliche Materialien enthalten,
- der zweite Bereich (4B) mit einem Anschlussmaterial (A) stärker benetzbar ist als der erste Bereich (4A),
- der metallische Träger (101) stellenweise von einem strahlungsundurchlässigen Gehäusekörper (6) bedeckt ist und der metallische Träger (101) und der Gehäusekörper (6) den Grundkörper (100) bilden, und
- der Gehäusekörper (6) den metallischen Träger (101) mit den Anschlussstellen (A1, A2) und die Kontrollstelle (4) elektrisch voneinander isoliert und mechanisch miteinander verbindet.

2. Elektronisches Bauteil (EBT) nach Anspruch 1,
bei dem der metallische Träger (101) und/oder die Kontrollstelle (4) in den Gehäusekörper (6) zumindest teilweise eingebettet sind.

3. Elektronisches Bauteil (EBT) nach einem der vorhergehenden Ansprüche,
bei dem die Anschlussstellen (A1, A2) und die Kontrollstelle (4) mit demselben Material gebildet sind.

4. Elektronisches Bauteil (EBT) nach einem der vorhergehenden Ansprüche,
bei dem die zumindest eine Seitenfläche (3) des Grundkörpers (100) stellenweise mittels Vereinzeln erzeugt ist.

5. Elektronisches Bauteil (EBT) nach einem der vorhergehenden Ansprüche,
bei dem der erste Bereich (4A) der Kontrollstelle (4) mit einem Metall gebildet ist.

6. Elektronisches Bauteil (EBT) nach einem der Ansprüche 1 bis 4,
bei dem der erste Bereich (4A) der Kontrollstelle (4) mit einem keramischen Material gebildet ist.

7. Elektronisches Bauteil (EBT) nach einem der vorhergehenden Ansprüche,
bei dem der zweite Bereich (4B) der Kontrollstelle (4) eine metallische Beschichtung aufweist.

8. Optoelektronische Vorrichtung (130), mit
- einem elektronischen Bauteil (EBT) gemäß einem der vorhergehenden Ansprüche,
- einem Kontaktträger (110), der zur elektrischen Kontaktierung des elektronischen Bauteils (EBT) dient, wobei an einer Oberfläche (120) des Kontaktträgers (110) zumindest ein Montagebereich (140) ausgebildet ist,
- der zweite Bereich (4B) der Kontrollstelle (4) mittels des Anschlussmaterials (A) stoffschlüssig mit dem Montagebereich (140) verbunden ist, wobei
- die Kontrollstellen (4) von der Oberfläche (120) des Kontaktträgers (110) aus frei einsehbar sind.

9. Optoelektronische Vorrichtung (130) nach dem vorhergehenden Anspruch,
bei dem das Anschlussmaterial (A) ein Lot ist.

## Claims

1. Electronic device (EBT), with
- a base body (100) having an upper side (1A) and a lower side (1B) opposite the upper side, the base body (100) having a metallic carrier (101) and the metallic carrier (101) having terminals (A1, A2) on its lower side (1B) for electrically contacting the device (EBT),
- an electronic component (2) arranged on the upper side (1A) of the base body (100) on the base body (100), wherein
- the base body (100) has at least one side surface (3) which has at least one control point (4) with a first region (4A) and a second region (4B),
- the second region (4B) is formed as an indentation (5) in the first region (4A),
- the first (4A) and the second region (4B) contain different materials,
- the second region (4B) is more wettable with a connection material (A) than the first region (4A),
- the metallic carrier (101) is partially covered by a radiopaque housing body (6) and the metallic carrier (101) and the housing body (6) form the base body (100), and
- the housing body (6) electrically isolates the metallic carrier (101) with the terminals (A1, A2) and the control point (4) and mechanically connects them together.

2. Electronic device (EBT) according to claim 1,
in which the metallic carrier (101) and/or the control point (4) are at least partially embedded in the housing body (6).

3. Electronic device (EBT) according to one of the preceding claims,
in which the terminals (A1, A2) and the control point (4) are formed with the same material.

4. Electronic device (EBT) according to one of the preceding claims,
in which the at least one side surface (3) of the base body (100) is produced in places by means of separation.

5. Electronic device (EBT) according to one of the preceding claims,
in which the first region (4A) of the control point (4) is formed with a metal.

6. Electronic device (EBT) according to any of claims 1 to 4, in which the first region (4A) of the control point (4) is formed with a ceramic material.

7. Electronic device (EBT) according to one of the preceding claims,
in which the second region (4B) of the control point (4) has a metallic coating.

8. Optoelectronic apparatus (130), with
- an electronic device (EBT) in accordance with one of the preceding claims,
- a contact carrier (110) which serves for electrically contacting the electronic device (EBT), wherein at least one mounting region (140) is formed on a surface (120) of the contact carrier (110),
- the second region (4B) of the control point (4) is connected to the mounting region (140) by means of the connecting material (A) in a material-locking manner, wherein
- the control points (4) are freely visible from the surface (120) of the contact carrier (110).

9. Optoelectronic apparatus (130) according to the preceding claim,
in which the connection material (A) is a solder.

## Revendications

1. Composant électronique (EBT), comportant
- un corps de base (100) présentant une face supérieure (1A) ainsi qu'une face inférieure (1B) opposée à la face supérieure, le corps de base (100) disposant d'un support métallique (101) et le support métallique (101) présentant des bornes de raccordement (A1, A2) sur sa face inférieure (1B) pour le contact électrique du composant (EBT),
- un composant électronique (2) disposé sur la face supérieure (1A) du corps de base (100) sur le corps de base (100),
- le corps de base (100) présentant au moins une surface latérale (3) disposant d'au moins un point de contrôle (4) comportant une première zone (4A) et une deuxième zone (4B),
- la deuxième zone (4B) étant formée comme une indentation (5) dans la première zone (4A),
- la première (4A) et la deuxième zone (4B) contenant des matériaux différents,
- la deuxième zone (4B) étant plus mouillable avec un matériau de raccordement (A) que la première zone (4A),
- le support métallique (101) étant partiellement recouvert par un corps de boîtier radio-opaque (6) et le support métallique (101) et le corps de boîtier (6) formant le corps de base (100), et
- le corps de boîtier (6) isolant électriquement le support métallique (101) des bornes de raccordement (A1, A2) et du point de contrôle (4) et les reliant mécaniquement entre eux.

2. Composant électronique (EBT) selon la revendication 1, dans lequel le support métallique (101) et/ou le point de contrôle (4) sont au moins partiellement incorporés au corps du boîtier (6).

3. Composant électronique (EBT) selon l'une des revendications précédentes,
dans laquelle les bornes de raccordement (A1, A2) et le point de contrôle (4) sont formés avec le même matériau.

4. Composant électronique (EBT) selon l'une des revendications précédentes,
dans lequel au moins une surface latérale (3) du corps de base (100) est créée par endroits au moyen d'une séparation.

5. Composant électronique (EBT) selon l'une des revendications précédentes,
dans lequel la première zone (4A) du point de contrôle (4) est formée avec un métal.

6. Composant électronique (EBT) selon l'une des revendications 1 à 4,
dans lequel la première zone (4A) du point de contrôle (4) est formée avec un matériau céramique.

7. Composant électronique (EBT) selon l'une des revendications précédentes,
dans lequel la deuxième zone (4B) du point de contrôle (4) présente un revêtement métallique.

8. Dispositif optoélectronique (130), comportant
- un composant électronique (EBT) selon l'une des revendications précédentes,
- un support de contact (110) servant à établir le contact électrique du composant électronique (EBT), au moins une zone de montage (140) étant formée sur une surface (120) du support de contact (110),
- la deuxième zone (4B) du point de contrôle (4) étant reliée par adhérence à la zone de montage (140) au moyen du matériau de raccordement (A),
- les points de contrôle (4) étant directement visibles depuis la surface (120) du support de contact (110).

9. Dispositif optoélectronique (130) selon la revendication précédente,
dans lequel le matériau de raccordement (A) est un fil à plomb.
